(19) Europäisches Patentamt

European Patent Office

Office européen des brevets

(11) **EP 0 865 164 B1**

(12) **FASCICULE DE BREVET EUROPEEN**

(45) Date de publication et mention
de la délivrance du brevet:
**28.04.2004   Bulletin 2004/18**

(51) Int Cl.⁷: **H03K 19/0185**, H03K 3/356

(21) Numéro de dépôt: **98400587.6**

(22) Date de dépôt: **12.03.1998**

(54) **Circuit convertisseur de niveaux analogiques**

Konvertershaltung für analoge Pegel

Analog level conversion circuit

(84) Etats contractants désignés:
**DE GB IT NL SE**

(30) Priorité:  **14.03.1997  FR 9703110**

(43) Date de publication de la demande:
**16.09.1998   Bulletin 1998/38**

(73) Titulaire: **ATMEL NANTES SA**
**44300 Nantes (FR)**

(72) Inventeurs:
• **Gerber, Rémi**
**44300 Nantes (FR)**
• **Silloray, Janick**
**44300 Nantes (FR)**

(74) Mandataire: **Fréchède, Michel et al**
**Cabinet Plasseraud**
**84, rue d'Amsterdam**
**75440 Paris Cédex 09 (FR)**

(56) Documents cités:
**US-A- 4 039 862**          US-A- 5 113 097
**US-A- 5 204 557**          US-A- 5 455 526
**US-A- 5 486 778**

## EP 0 865 164 B1

**Description**

L'invention concerne un circuit convertisseur de niveaux analogiques, susceptible d'être utilisé pour la conversion de signaux logiques assurant la transmission de l'information entre différentes parties de circuits intégrés.

A l'heure actuelle, la mise en oeuvre de circuits intégrés implique la conception, le dessin puis l'intégration de circuits de plus en plus complexes, en raison des fonctionnalités nouvelles successives remplies par ces derniers.

Alors que l'un des objectifs majeurs, jusqu'à un passé récent, pour la mise en oeuvre de tels circuits, a consisté, au prix d'efforts de recherche et développement très importants, à augmenter régulièrement les possibilités d'intégration, par passages successifs à des technologies de gravure d'une finesse micronique à une finesse submicronique, afin de satisfaire à l'apparition des fonctionnalités nouvelles précitées au moyen d'une augmentation de la densité d'intégration, il est également apparu nécessaire, en raison notamment de la variété et de la diversité des circuits de base nécessaires à la réalisation de ces fonctions, d'assurer une alimentation électrique spécifique, par zones fonctionnelles, de ces circuits de base ou groupes de circuits de base. En effet, les phénomènes physiques mis en jeu par ces circuits de base ou groupes de circuits de base sont suffisamment différents pour justifier d'une alimentation électrique spécifique de ces derniers, afin de permettre, notamment, un fonctionnement optimum de ceux-ci en fonction de leur tension d'alimentation.

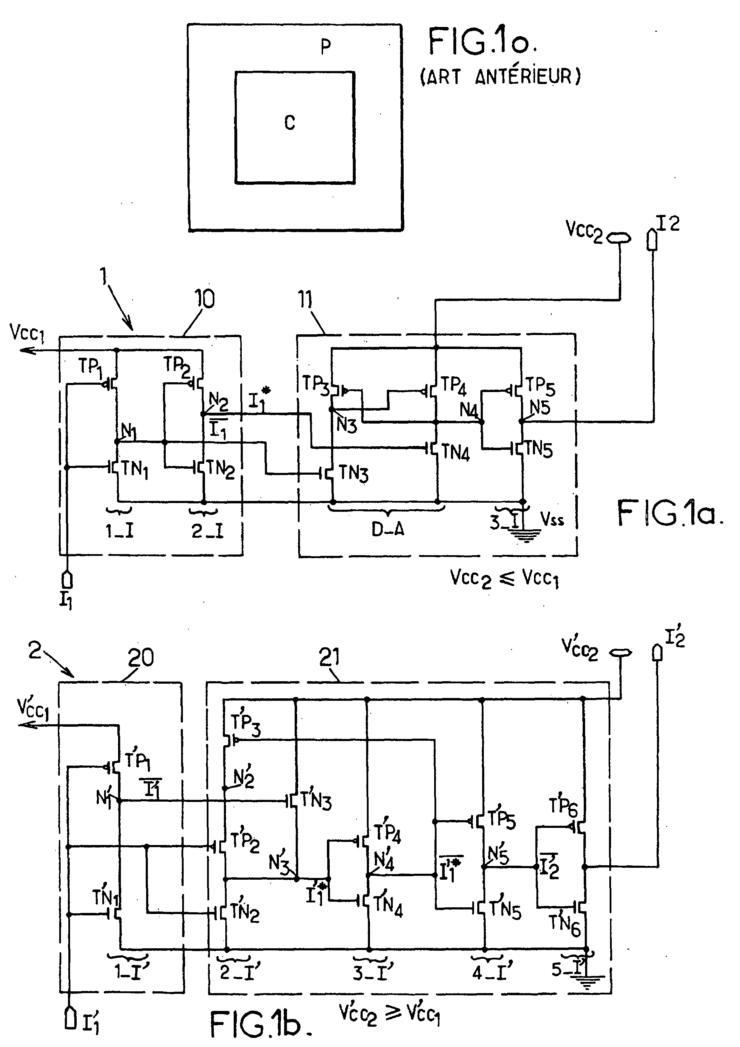

Ainsi, à titre d'exemple non limitatif, dans le cas d'une zone mémoire à accès aléatoire, mémoire RAM, de telles zones mémoires comportent habituellement dans les circuits intégrés actuels, ainsi que représenté en figure 1$_o$, une zone centrale ou coeur C, formée par des cellules mémoires dans lesquelles des données numériques peuvent être mémorisées, et une zone périphérique P, formée par des circuits tampon, permettant l'accès en écriture/lecture des cellules mémoires précitées.

Lorsque la technologie utilisée pour la réalisation de tels circuits mémoire par exemple est la technologie CMOS, il est avantageux de maintenir la tension d'alimentation des cellules mémoires à une valeur relativement élevée, afin de bénéficier de la vitesse de commutation plus élevée, et donc de la plus grande rapidité en lecture/écriture, des zones mémoires précitées.

Toutefois, l'alimentation de la zone périphérique, formée par les circuits tampons, à une tension aussi élevée, ne se justifie pas.

En effet, d'une première part, le maintien d'une tension d'alimentation élevée de la zone tampon précitée est susceptible d'entraîner le maintien d'un niveau de bruit non négligeable sur les signaux d'entrée/sortie, c'est-à-dire d'écriture/lecture des cellules mémoires, transmis par la zone tampon précitée.

D'une deuxième part, le maintien d'une tension d'alimentation relativement élevée de la zone tampon maintient un niveau de consommation électrique important alors que, au niveau de ces circuits tampons, la vitesse de commutation n'est pas indispensable, du fait de la fonction de tampon de ces circuits, ce qui grève manifestement l'autonomie réelle d'éléments fonctionnels sophistiqués tels que les micro-ordinateurs portables alimentés sur batterie d'accumulateurs.

Enfin, dans le cadre de travaux de développement actuels ou prévisibles visant à réduire l'amplitude de commutation de signaux logiques d'un niveau analogique haut à un niveau analogique bas, il apparaît opportun de pouvoir disposer de dispositifs convertisseurs de niveaux analogiques d'une valeur faible, moins couramment utilisée, à une valeur plus standard, habituellement utilisée, afin d'assurer une adaptation progressive de circuits intégrés ou de parties de circuits intégrés nouvellement développés, et alimentés par ces valeurs de tension d'alimentation moins courantes, à des circuits intégrés classiques alimentés par ces valeurs d'alimentation standard.

La présente invention a pour objet la mise en oeuvre de tels circuits convertisseurs de niveaux analogiques de signaux logiques échangés entre différentes parties de circuits intégrés.

Un objet de la présente invention est en conséquence la mise en oeuvre d'un circuit convertisseur de niveaux analogiques de signaux logiques échangés entre une première zone fonctionnelle d'un circuit intégré alimentée par une alimentation électrique à une première valeur de tension en deuxièmes signaux logiques d'une deuxième zone fonctionnelle de ce circuit intégré alimentée par une alimentation électrique à une deuxième valeur de tension, supérieure à la première.

Un autre objet de la présente invention est également, dans un circuit intégré de type mémoire à accès aléatoire comportant une première zone fonctionnelle, constituée par un ensemble de cellules mémoires, et une deuxième zone fonctionnelle, constituée par des circuits tampons, la première zone fonctionnelle étant alimentée par une première valeur de tension et la deuxième zone fonctionnelle étant alimentée par une deuxième valeur de tension, inférieure à la première, la première zone fonctionnelle délivrant à la deuxième zone fonctionnelle des signaux logiques d'entrée et des signaux logiques de commande de niveau analogique adapté à la première valeur de tension et la deuxième zone fonctionnelle délivrant à la première zone fonctionnelle des signaux logiques de sortie à un niveau analogique adapté à la deuxième valeur de tension, un convertisseur de niveaux analogiques de ces signaux logiques d'entrée, signaux logiques de commande et signaux logiques de sortie.

Un autre objet de la présente invention est également, dans un circuit intégré de type mémoire à accès aléatoire comportant une première zone fonctionnelle, ensemble de cellules mémoires, et une deuxième zone fonc-

2

tionnelle, constituée par des circuits tampons, la première zone fonctionnelle étant alimentée par une première valeur de tension et la deuxième zone fonctionnelle étant alimentée par une deuxième valeur de tension, supérieure à la première, la première zone fonctionnelle délivrant à la deuxième zone fonctionnelle des signaux logiques d'entrée et des signaux logiques de commande de niveau analogique adapté à la première valeur de tension et la deuxième zone fonctionnelle délivrant à la première zone fonctionnelle des signaux logiques de sortie à un niveau analogique adapté à la deuxième valeur de tension, un convertisseur de niveaux analogiques de ces signaux logiques d'entrée, signaux logiques de commande et signaux logiques de sortie.

Un autre objet de la présente invention est enfin, dans un circuit intégré de type mémoire à accès aléatoire comportant une première zone fonctionnelle, constituée par des circuits tampons, et par une deuxième zone fonctionnelle, formée par des cellules mémoires, la première et la deuxième zone fonctionnelle étant alimentées par une alimentation électrique commutable entre une première et une deuxième valeur de tension, la deuxième valeur de tension étant inférieure, égale ou supérieure à la première, la première zone fonctionnelle délivrant vers la deuxième zone fonctionnelle des signaux logiques d'entrée et des signaux logiques de commande à un niveau logique adapté à la première, respectivement deuxième valeur de tension, et la deuxième zone fonctionnelle délivrant vers la première zone fonctionnelle des signaux logiques de sortie à un niveau analogique adapté à la première, respectivement deuxième valeur de tension, un convertisseur configurable de niveaux analogiques de ces signaux logiques d'entrée, signaux logiques de commande et signaux logiques de sortie entre les niveaux analogiques de la première et de la deuxième valeur de tension, permettant, soit la conversion niveau analogique haut/niveau analogique bas, et réciproquement, entre première et une deuxième zone fonctionnelle, soit une conversion niveau analogique bas/niveau analogique haut, et réciproquement, entre première et deuxième zone fonctionnelle, ou encore une conversion entre même niveau analogique haut, respectivement bas, en fonction de la valeur relative de la première et de la deuxième valeur de tension.

Le circuit convertisseur de niveaux analogiques de premiers signaux logiques d'une première zone fonctionnelle d'un circuit intégré alimentée par une alimentation électrique à une première valeur de tension, en deuxièmes signaux logiques d'une deuxième zone fonctionnelle de ce circuit intégré alimentée par une alimentation électrique à une deuxième valeur de tension, supérieure à la première valeur de tension, ces valeurs de tension étant définies par rapport à une même tension de référence, conformément à l'objet de la présente invention, est remarquable en ce qu'il comporte, connectés en cascade par rapport à cette tension de référence commune, alimenté à la première valeur de tension, un étage inverseur recevant sur une borne d'entrée un signal logique d'entrée constitué par lesdits premiers signaux logiques, dont le niveau analogique est adapté à celui de la première valeur de tension, et délivrant un signal logique d'entrée inversé, ainsi qu'un module convertisseur amplificateur alimenté à la deuxième valeur de tension et qui délivre par amplification un signal de sortie converti en phase avec le signal logique d'entrée et dont le niveau analogique est adapté à celui de la deuxième valeur de tension, constituant lesdits deuxièmes signaux logiques.

Le circuit convertisseur de niveaux analogiques de signaux logiques d'une première à une deuxième valeur de tension, conforme à l'objet de la présente invention, dans sa version deuxième valeur de tension supérieure à la première valeur de tension, trouve application à la réalisation de circuits convertisseurs de niveaux analogiques niveau bas - niveau haut, en particulier de convertisseurs configurables pour circuits intégrés.

Il sera mieux compris à la lecture de la description et à l'observation des dessins ci-après, dans lesquels :

- la figure 1a représente un circuit convertisseur de niveaux analogiques de signaux logiques niveau haut - niveau bas, tel que connu du brevet US-A-5 113 097, la deuxième valeur de tension étant inférieure à la première valeur de tension d'alimentation ;
- la figure 1b représente un circuit convertisseur de niveaux analogiques de signaux logiques niveau bas - niveau haut conforme à l'objet de la présente invention, la deuxième valeur de tension étant supérieure à la première valeur de tension d'alimentation ;

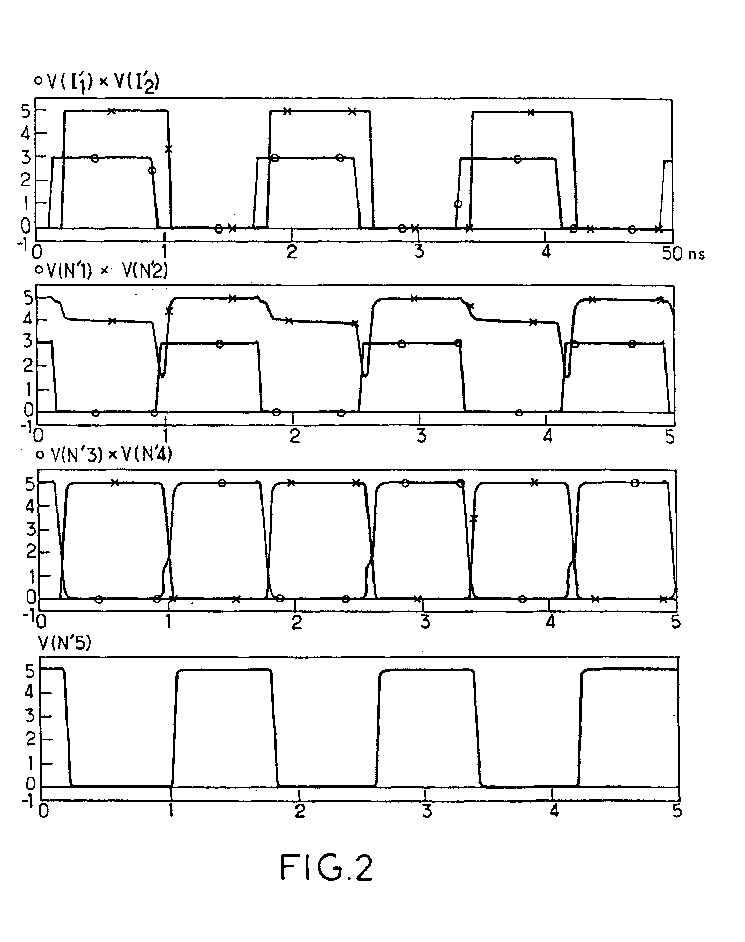

- la figure 2 représente un chronogramme des signaux relevés en des points de test remarquables de la figure 1b ;

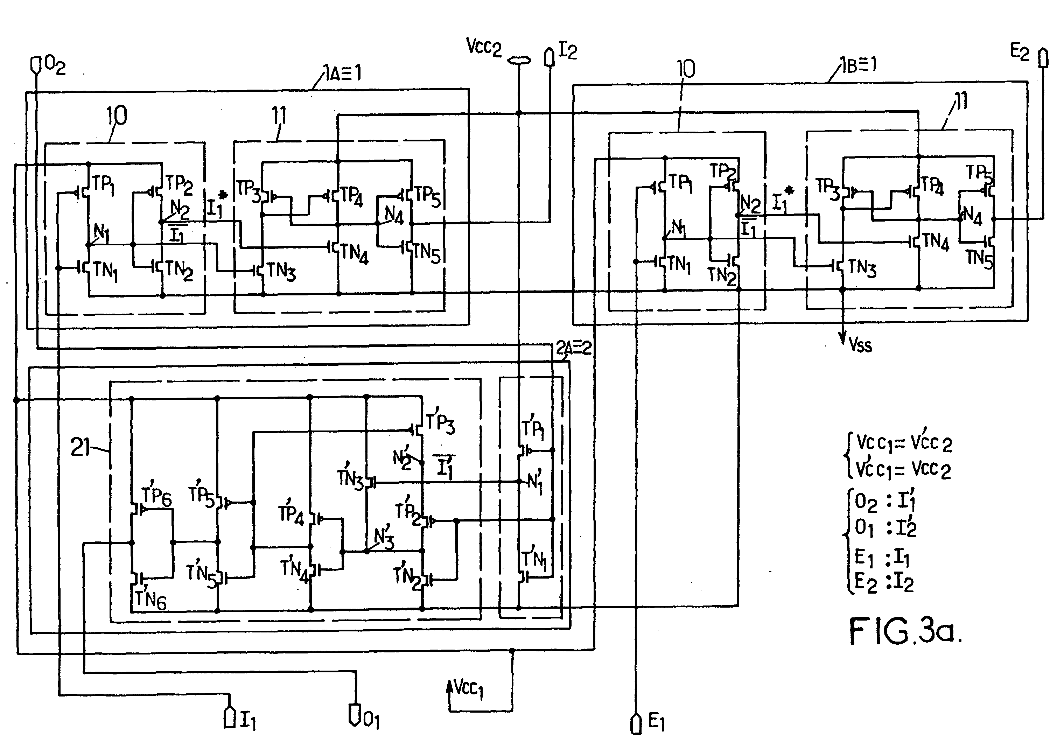

- la figure 3a représente un convertisseur de niveaux analogiques de signaux logiques, signaux d'entrée, signaux de commande et signaux de sortie échangés entre la partie centrale d'une mémoire vive alimentée à une première valeur de tension et la partie périphérique d'accès à cette partie centrale, alimentée à une deuxième valeur de tension, inférieure à la première valeur de tension ;

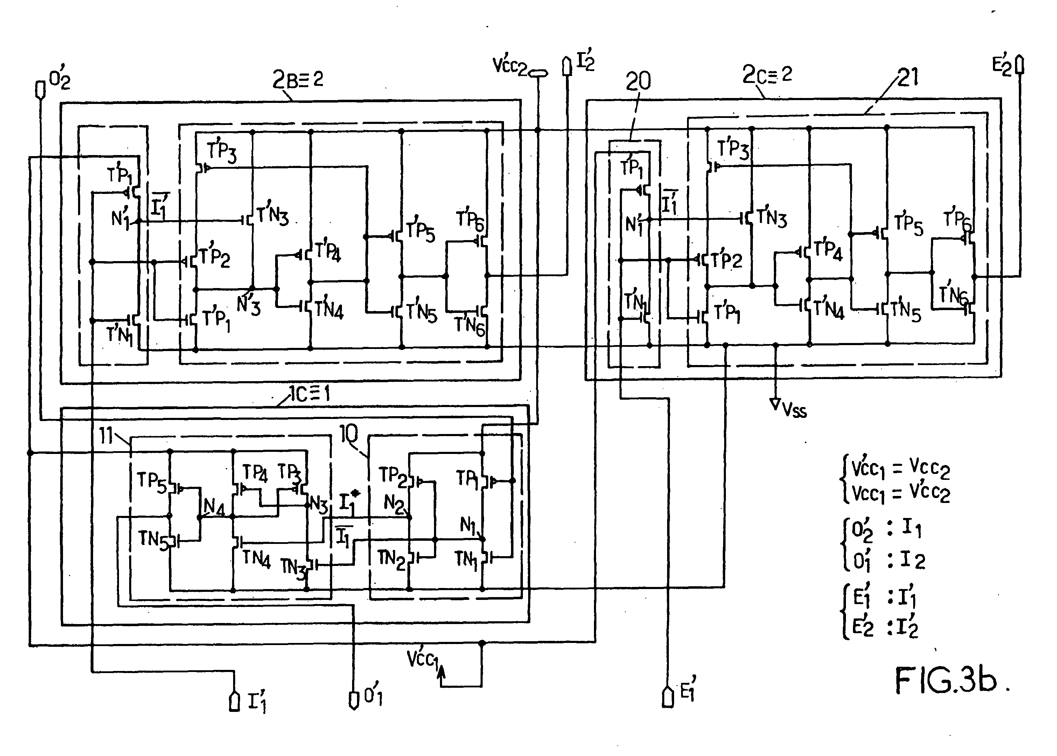

- la figure 3b représente un convertisseur de niveaux analogiques de signaux logiques, signaux d'entrée, signaux de commande et signaux de sortie échangés entre la partie centrale d'une mémoire vive alimentée à une première valeur de tension et la partie périphérique d'accès à cette partie centrale, alimentée à une deuxième valeur de tension, supérieure à la première valeur de tension ;

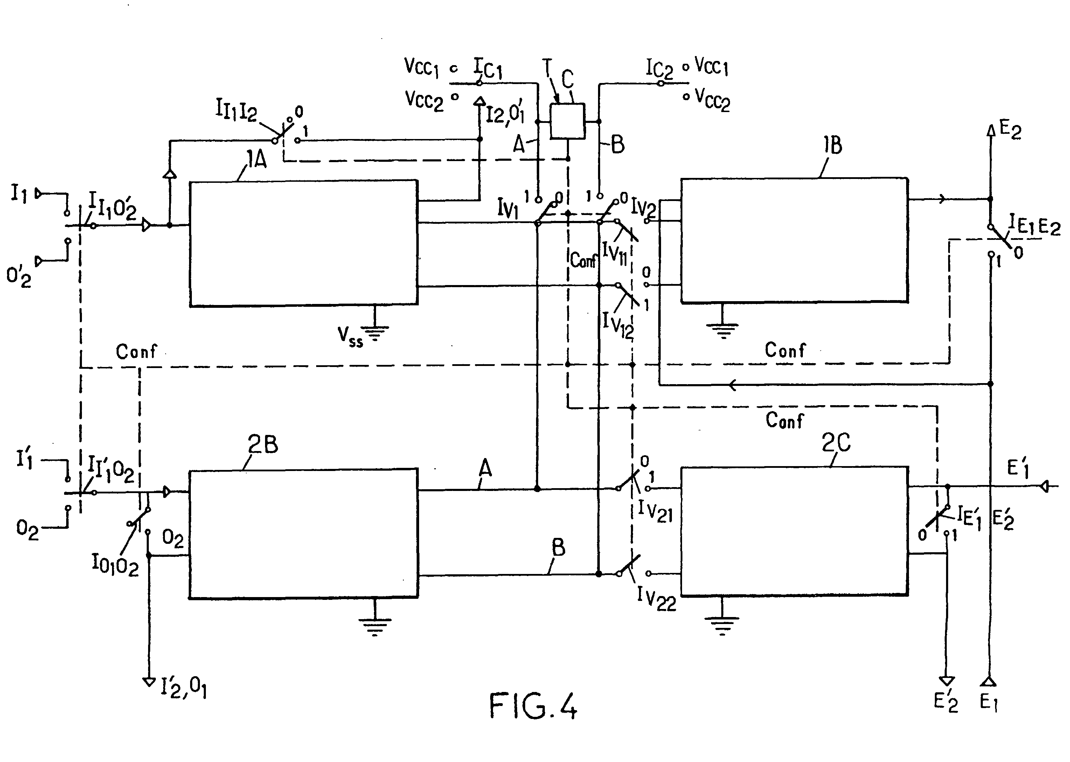

- la figure 4 représente un schéma d'implantation d'un convertisseur de niveaux analogiques de signaux logiques, signaux d'entrée, signaux de commande et signaux de sortie échangés entre la partie centrale d'une mémoire vive et la partie périphérique d'accès à cette partie centrale, cette partie centrale et cette partie périphérique étant susceptibles d'être alimentées par une alimentation commutable entre une première et une deuxième valeur de tension, cette deuxième valeur de tension étant inférieure, égale ou supérieure à la première valeur de tension, ce convertisseur étant configurable automatiquement en fonction de la valeur relative de la première et de la deuxième valeur de tension.

Une description plus détaillée d'un circuit convertisseur de niveaux analogiques, conforme à l'objet de la présente invention, sera maintenant donnée en liaison avec les figures 1b dans le cas de la conversion de niveaux analogiques niveau bas - niveau haut

Sur la figure relative à l'art antérieur, Fig. $1_0$, on a représenté le schéma d'implantation globale d'une mémoire vive, ou mémoire à accès aléatoire, généralement mise en oeuvre dans les circuits intégrés actuels.

Ainsi que représenté sur la figure relative à l'art antérieur précitée, cette mémoire vive comporte en fait la zone centrale, notée C, comprenant une pluralité de cellules mémoires adressables en lecture/écriture et une zone périphérique, notée P, constituée par des circuits tampons, plus communément appelés et désignés par "*buffer*" en langage anglo-saxon et permettant l'accès en écriture/lecture aux cellules mémoires de la zone centrale C précitée.

Dans toute la description qui suit et par convention purement non limitative, on indique que la zone centrale C constitue, pour le circuit intégré précité, une première zone fonctionnelle alimentée par une alimentation électrique à une première valeur de tension, alors que la zone périphérique P constitue pour ce circuit intégré une deuxième zone fonctionnelle alimentée par une alimentation électrique à une deuxième valeur de tension. Bien entendu, la première et la deuxième valeur de tension sont définies par rapport à une même tension de référence, la tension de masse du circuit intégré par exemple.

Compte tenu des indications précédentes données en liaison avec la figure $1_0$ relative à l'art antérieur, on indique que le circuit convertisseur de niveaux analogiques de signaux logiques, objet de la présente invention, permet en fait d'assurer une conversion de premiers signaux logiques adaptés à la première zone fonctionnelle, en deuxièmes signaux logiques adaptés à la deuxième zone fonctionnelle pour assurer finalement le fonctionnement de l'une et l'autre zone fonctionnelle, compte tenu de la valeur d'alimentation de la première et de la deuxième zone fonctionnelle précitées, chaque valeur d'alimentation pouvant par exemple être distincte, ainsi que mentionné précédemment dans la description.

Par signaux logiques adaptés à la première, respectivement à la deuxième zone fonctionnelle en fonction de la tension d'alimentation de celles-ci, on indique que, par convention, et sans nuire nullement à la généralité de la description ci-après, chaque signal logique adapté à la zone fonctionnelle correspondante présente par exemple un niveau logique bas égal à la tension de référence et un niveau logique haut dont la valeur analogique est égale ou inférieure à celle de la tension d'alimentation correspondante.

Dans le cadre de la figure 1b, la première valeur de tension est notée $V'CC_1$ et la deuxième valeur de tension est notée $V'CC_2$ avec $V'CC_2$ supérieure ou égale à $V'CC_1$.

D'une manière générale, on indique que la valeur de la deuxième tension $V'CC_2$ dans le cas de la mise en oeuvre de la figure 1b n'est pas nécessairement égale à la valeur de la première tension $VCC_1$ de la figure 1a et que, de la même manière, $V'CC_1$, valeur de la première tension dans le cas de la mise en oeuvre de la figure 1b, n'est pas nécessairement égale à la deuxième valeur de tension $VCC_2$ dans le cas de la mise en oeuvre du dispositif convertisseur de la figure 1a. Bien entendu, le cas de l'égalité respective des tensions précitées permet la mise en oeuvre tant du dispositif convertisseur représenté en figure la que du dispositif convertisseur représenté en figure 1b pour assurer l'échange de signaux d'écriture-lecture, de signaux de commande, par exemple, entre la zone centrale C de la mémoire vive précédemment mentionnée dans la description et la zone périphérique P précitée ainsi qu'il sera décrit ultérieurement dans la description.

Dans le cadre de la mise en oeuvre du circuit convertisseur de niveaux analogiques objet de la présente invention, tel que représenté en figure 1b, la première zone fonctionnelle du circuit intégré est alimentée par une alimentation électrique à une première valeur de tension $V'CC_1$ et la deuxième zone fonctionnelle de ce même circuit intégré est alimentée par une alimentation électrique à une deuxième valeur de tension, la tension $V'CC_2$ précédemment mentionnée, cette deuxième valeur de tension étant alors supérieure ou égale à la première valeur de tension.

Bien entendu, les valeurs de tension précitées sont définies par rapport à une même tension de référence, la tension de masse du circuit intégré VSS.

Le dispositif convertisseur de niveaux analogiques 2 objet de la présente invention, tel que représenté en figure 1b, permet alors d'effectuer la conversion de tension de premiers signaux logiques $I'_1$ adaptés à la première valeur d'alimentation $V'CC_1$ de la première zone fonctionnelle du circuit intégré en deuxièmes signaux logiques $I'_2$ adaptés à la deuxième valeur de tension d'alimentation $V'CC_2$ de la deuxième zone fonctionnelle de ce même circuit intégré. On comprend bien sûr que les conditions d'adaptation aux alimentations aux première et deuxième valeurs de tension correspondent à celles déjà indiquées dans la description.

Ainsi que représenté sur la figure 1b précitée, le circuit convertisseur de niveaux analogiques 2 comprend successivement, connectés en cascade par rapport à la tension de référence commune VSS précédemment mentionnée, un étage inverseur noté 1-I' portant la référence 20, recevant sur une borne d'entrée un signal logique d'entrée constitué par les premiers signaux logiques, c'est-à-dire le signal $I'_1$, signal dont le niveau analogique est adapté à celui de la première valeur de tension $V'CC_1$. L'étage inverseur 1-I' délivre un signal logique d'entrée inversé noté $\bar{I}'_1$.

Ainsi que représenté sur la figure 1b précitée, l'étage inverseur 1-I' peut être constitué par un transistor de PMOS $T'P_1$ dont l'électrode de source est connectée à la première valeur de tension $V'CC_1$ et un transistor de type NMOS $T'N_1$, les transistors $T'P_1$ et $T'N_{1N}$ étant connectés en série, les électrodes de drain des transistors $T'P_1$ et $T'N_1$ étant interconnectées en un noeud ou point commun $N'_1$ et l'électrode de source du transistor $T'N_1$ étant connectée à la tension de référence VSS. Les électrodes de grille des transistors $T'P_1$ et $T'N_1$ sont interconnectées en parallèle et reçoivent le signal logique d'entrée $I'_1$ précité.

En outre, le circuit convertisseur de niveaux analogiques 2 tel que représenté en figure 1b comporte, alimenté à la deuxième valeur de tension $V'CC_2$ un module convertisseur amplificateur 21 recevant notamment sur une borne d'entrée, le signal logique d'entrée inversé $\bar{I}'_1$ délivré par l'étage inverseur 20 précédemment cité, le module convertisseur amplificateur 21 délivrant par amplification un signal logique de sortie noté $I'_2$ en phase avec le signal logique d'entrée $I'_1$ et dont le niveau analogique est adapté à celui de la deuxième valeur de tension $V'CC_2$. Le signal logique de sortie $I'_2$ constitue les deuxièmes signaux logiques obtenus par conversion à partir des premiers signaux logiques constituant le signal logique d'entrée $I'_1$.

Une description plus détaillée du module convertisseur-amplificateur 21 sera maintenant donnée en liaison avec la figure 1b.

Selon la figure précitée, le module convertisseur-amplificateur 21 comporte avantageusement un premier étage inverseur noté 2-I', ce premier étage inverseur étant interconnecté à la deuxième valeur de tension $V'CC_2$ par l'intermédiaire d'un transistor de réaction de type PMOS noté $T'P_3$. Le premier étage inverseur est ainsi formé par un transistor de type PMOS $T'P_2$ interconnecté en série avec un transistor de type NMOS $T'N_2$, l'électrode de drain des transistors $T'P_2$ et $T'N_2$ étant interconnectée en commun en un point ou noeud $N'_3$. L'électrode de source du transistor de réaction $T'P_3$ est interconnectée à la deuxième tension d'alimentation $V'CC_2$ et l'électrode de drain du transistor $T'P_3$ est interconnectée en un noeud ou point commun $N'_2$ à l'électrode de source du transistor $T'P_2$. L'électrode de source du du transistor $T'N_2$ est interconnectée à la tension de référence VSS. Enfin, les électrodes de grille des transistors $T'P_2$ et $T'N_2$ sont interconnectées en parallèle et reçoivent le signal logique d'entrée $I'_1$. Le noeud $N'_3$, borne de sortie du premier étage inverseur 2-I' délivre alors un signal logique d'entrée inversé noté pour cette raison $I'^*_1$ présentant un niveau analogique sensiblement égal à celui de la deuxième valeur de tension d'alimentation $V'CC_2$.

En outre, le module convertisseur amplificateur 21 comprend un deuxième étage inverseur référencé 3-I', lequel reçoit sur une borne d'entrée le signal logique d'entrée inversé $I'^*_1$ délivré par le premier étage inverseur 2-I'.

En outre, ainsi qu'on l'observera sur la figure 1b, le module convertisseur-amplificateur 21 comprend un transistor de commande cumulative de type NMOS noté $T'N_3$, ce transistor de commande cumulative étant connecté entre la deuxième valeur de tension $V'CC_2$ et l'entrée du deuxième étage inverseur 3-I', c'est-à-dire de noeud $N'_3$ précité. L'électrode de grille du transistor de commande cumulative $T'N_3$ est reliée en sortie de l'étage inverseur 1-I', alimenté par la première valeur de tension $V'CC_1$. Le deuxième étage inverseur 3-I', formé par les transistors $T'P_4$ et $T'N_4$ délivre sur le point commun ou noeud $N'_4$ d'interconnexion des électrodes de drain des transistors $T'P_4$ et $T'N_4$ un signal logique d'entrée dupliqué noté $\bar{I}'^*_1$ et dont le niveau analogique est adapté à celui de la deuxième valeur de tension $V'CC_2$. En outre, et selon un aspect particulièrement avantageux du module convertisseur-amplificateur 21, la sortie du deuxième étage inverseur 3-I', c'est-à-dire le noeud $N'_4$, délivrant le signal logique d'entrée dupliqué $\bar{I}'^*_1$, est interconnectée en réaction à l'électrode de grille du transistor de réaction $T'P_3$ précédemment mentionné.

En outre, le module convertisseur amplificateur 21 comprend un troisième étage inverseur référencé 4-I' recevant le signal logique d'entrée dupliqué $\bar{I}'^*_1$ et délivrant un signal logique d'entrée inverse calibré noté $\bar{I}'_2$. Le troisième étage inverseur 4-I' est constitué par exemple par un transistor PMOS $T'P_5$ dont l'électrode de source est connectée à la deuxième tension d'alimentation $V'CC_2$ d'un transistor NMOS $T'N_5$ connecté en série avec le transistor $T'P_5$, les électrodes de drain des transistors $T'P_5$ et $T'N_5$ étant connectés en un point ou noeud commun, le noeud $N'_5$ constituant la sortie délivrant le signal logique d'entrée inversé calibré précédemment cité $\bar{I}'_2$. L'électrode de source du transistor $T'N_5$ est connectée à la tension de référence VSS. Les électrodes de grille des transistors $T'P_5$ et $T'N_5$ sont connectées en parallèle au noeud $N'_4$.

Enfin, le module convertisseur-amplificateur 21 comprend un quatrième étage inverseur noté 5-I' recevant le signal logique d'entrée inversé calibré $\bar{I}'_2$ et délivrant le signal logique de sortie $I'_2$, ce signal étant en phase avec le signal logique d'entrée et dont le niveau analogique est égal à celui de la deuxième valeur de tension $V'CC_2$.

Le fonctionnement du circuit convertisseur de niveaux logiques 2 niveau bas - niveau haut représenté en figure 1b est le suivant.

Lorsque le signal logique d'entrée $I'_1$ passe de VSS = 0 V à $V'CC_1$ = 3 V, la tension au noeud $N'_1$ passe à VSS = 0 V, le transistor de commande cumulative $T'N_3$ étant ainsi commandé à l'état bloqué. La tension au noeud $N'_3$ est encore égale à $V'CC_2$ = 5 V et la tension au noeud $N'_4$ est encore égale à VSS = 0 V. Les transistors $T'P_3$, transistor de réaction et $T'N_2$ sont ainsi encore passants. Le transistor $T'P_2$ est également passant car l'électrode de grille de ce dernier est à une différence de potentiel de 2 V ($V'CC_2$ - $V'CC_1$) par rapport à son électrode de source, noeud $N'_2$. La

tension au noeud $N'_2$ chute légèrement jusqu'à ce que le transistor $T'P_2$ passe à l'état bloqué. Le transistor $T'N_2$ étant à l'état passant, la tension au noeud $N'_3$ bascule à VSS = 0 V et la tension au noeud $N'_4$ bascule en conséquence à la valeur $V'CC_2$ = 5 V, ce qui a pour effet de bloquer le transistor de réaction $T'P_3$ en coupant le courant débité par la branche transistor $T'P_3$, transistor $T'P_2$, transistor $T'N_2$, premier inverseur 2-I en série avec le transistor $T'P_3$. La tension au noeud $N'_5$ passe à VSS = 0 V et le signal logique converti $I'_2$ délivré par la sortie du quatrième inverseur 5-I' passe à $V'CC_2$ = 5 V.

Lorsque le signal logique d'entrée passe de $V'CC_1$ = 3 V à VSS = 0 V, la tension au noeud $N'_1$ passe à $V'CC_1$ = 3 V et le transistor $T'N_3$ est rendu passant car la tension de grille de ce dernier, au noeud $N'_1$, est alors supérieure à sa tension de source, au noeud $N'_3$ laquelle, au départ est a VSS = 0 V. Le transistor $T'P_2$ est rendu passant alors que le transistor $T'P3$ est encore bloqué car la tension sur l'électrode de grille de ce dernier, noeud $N'_4$, est encore à $V'CC_2$ = 5 V. Ceci a pour effet, sur commande de réaction, de faire chuter la tension au noeud $N'_2$. Conjointement, la tension au noeud $N'_3$ monte sous l'effet de la conduction du transistor $T'N_3$, ce qui provoque le basculement de la tension au noeud $N'_4$ à VSS = 0 V. Ce basculement rend le transistor de réaction $T'P_3$ passant et provoque la montée du potentiel du noeud $N'_2$ à la tension $V'CC_2$ = 5 V. La tension au noeud $N'_4$ étant à VSS = 0 V, la tension au noeud $N'_5$, sortie du troisième inverseur 4-I' bascule à $V'CC_2$ = 5 V et le signal logique converti $I'_2$ délivré par le quatrième inverseur 5-I' passe à VSS = 0 V.

Sur la figure 2, on a représenté un chronogramme des signaux remarquables du circuit convertisseur 2 objet de la présente invention tel que représenté en figure 1b. Ces signaux remarquables sont les signaux présents aux points de test $N'_1$, $N'_2$, $N'_3$, $N'_4$ et $N'_5$ lorsque le signal logique d'entrée $I'_1$ correspond à un signal dont le niveau analogique est adapté à celui de la première tension d'alimentation $V'CC_1$, c'est-à-dire dans l'exemple donné précédemment, pour $V'CC_1$ = 3 V, à une valeur d'amplitude crête de 3 V, le signal logique converti constituant les deuxièmes signaux logiques, c'est-à-dire le signal $I'_2$ obtenu et adapté à la deuxième valeur de tension d'alimentation $V'CC_2$, ce signal présentant ainsi une valeur crête égale à 5 V dans l'exemple de réalisation précité pour $V'CC_2$ = 5 V. On indique que le signal converti $I'_2$ est en phase avec le signal d'entrée au retard de commutation près, lequel n'excède pas 50 ns. Une graduation intermédiaire de l'axe des abscisses sur la figure 2 correspond à la valeur de 10 ns précitée.

Bien entendu, un cas particulièrement intéressant de mise en oeuvre du circuit convertisseur de niveau analogique de signaux logiques 2 tel que représenté en figure 1b correspond à la situation dans laquelle la première tension d'alimentation $V'CC_1$ est égale à la deuxième tension d'alimentation $V'CC_2$.

Dans un tel cas, ainsi qu'il sera décrit maintenant de manière plus détaillée dans la description, le circuit convertisseur de niveau analogique précédemment décrit en figure 1b peut être utilisé de façon à réaliser un convertisseur de niveau analogique de signaux logiques d'entrée, de signaux logiques de commande et de signaux logiques de sortie échangés entre la zone centrale constituant la première zone fonctionnelle d'une mémoire vive et la zone périphérique constituant la deuxième zone fonctionnelle, zone d'accès à cette mémoire vive, d'un circuit intégré.

Un premier mode de réalisation d'un tel convertisseur sera décrit en liaison avec la figure 3a dans le cas non limitatif où ce convertisseur est utilisé par exemple dans un circuit intégré de type mémoire à accès aléatoire comportant une première zone fonctionnelle constituée par un ensemble de cellules mémoires, c'est-à-dire la partie centrale C précédemment mentionnée dans la description et par une deuxième zone fonctionnelle constituée par des circuits d'accès à ces cellules mémoires, la zone périphérique P précitée.

La première zone fonctionnelle est alimentée par une tension d'alimentation à une première valeur de tension $VCC_1$ égale à 5 V, par exemple, et la deuxième zone fonctionnelle est alimentée par une alimentation électrique à une deuxième valeur d'alimentation $VCC_2$ égale à 3 V, par exemple. La deuxième valeur de tension est inférieure à la première valeur de tension. La première zone fonctionnelle délivre vers la deuxième zone fonctionnelle des signaux logiques d'entrée notés $I_1$, des signaux logiques de commande notés $E_1$ dont le niveau analogique est adapté à la première valeur de tension, ainsi que mentionné précédemment dans la description.

La deuxième zone fonctionnelle délivre vers la première zone fonctionnelle des signaux logiques de sortie notés $O_2$, ces niveaux logiques de sortie étant bien entendu à un niveau analogique adapté à la deuxième valeur de tension précédemment citée, c'est-à-dire la valeur 3 V, dans l'exemple de réalisation décrit précédemment.

Le convertisseur objet de la présente invention, tel que représenté en figure 3a, permet d'assurer la conversion des signaux de sortie $O_2$ délivrés par la deuxième zone fonctionnelle, à une valeur analogique adaptée à la deuxième valeur de tension d'alimentation $VCC_2$, en signaux de sortie $O_1$ dont la valeur analogique est adaptée à la première valeur d'alimentation $VCC_1$ de la première zone fonctionnelle.

Dans ce but, ainsi que représenté sur la figure 3a précitée, le convertisseur comprend un circuit convertisseur de niveaux analogiques, des signaux logiques de sortie, ce circuit convertisseur portant la référence 2A étant strictement identique au circuit convertisseur représenté en figure 1b. Toutefois, et dans le seul but de simplifier la représentation du circuit convertisseur 2A dans le cadre du convertisseur représenté en figure 3a, le sens de propagation des signaux, pour le circuit convertisseur 2A, étant de droite à gauche sur la figure 3a alors qu'il est de gauche à droite dans le cas de la figure 1b, la représentation des éléments du circuit convertisseur 2A de la figure 3a est symétrique de celle de la figure 1b, les mêmes références désignant toutefois les mêmes éléments.

Pour le circuit convertisseur 2A et pour le convertisseur représenté en figure 3a, les signaux logiques de sortie $O_2$ constituent des signaux d'entrée. Ces signaux d'entrée présentent une valeur analogique adaptée à la deuxième valeur de tension $VCC_2$ égale 3 V dans l'exemple considéré pour la deuxième zone fonctionnelle. Le circuit convertisseur 2A délivre un signal logique de sortie converti, noté $O_1$, dont le niveau analogique est adapté à celui de la première valeur de tension, $VCC_1$ égale à 5 V dans l'exemple considéré. On comprend ainsi que le convertisseur de signaux analogiques objet de la présente invention, tel que représenté en figure 3a, comportant un circuit convertisseur tel que représenté en figure 1b, le circuit convertisseur 2A, permet ainsi d'assurer une conversion des signaux délivrés à cette deuxième valeur analogique par la zone mémoire précitée à la valeur 3 V, $O_2$, en signaux de sortie $O_1$ dont la valeur analogique est adaptée à celle de la tension d'alimentation de la première zone fonctionnelle, alimentée à la valeur 5 V. On comprend en particulier que dans le convertisseur représenté en figure 3a, le signal de sortie $O_2$ de la deuxième zone fonctionnelle joue le rôle du signal d'entrée $I'_1$ de la figure 1b, le signal de sortie converti $O_1$ joue le rôle du signal $I'_2$ de la figure 1b.

Bien entendu, le circuit convertisseur représenté en figure 1b permettent également la mise en oeuvre d'un convertisseur de niveau analogique de signaux logiques délivrés par une première zone fonctionnelle, constituée par exemple par un ensemble de cellules mémoires, d'une mémoire vive, et par une deuxième zone fonctionnelle constituée par des circuits tampons lorsque la première zone fonctionnelle précitée est alimentée par une alimentation électrique à une première valeur de tension $V'CC_1$ égale à 3 V, par exemple, et lorsque la deuxième zone fonctionnelle est au contraire alimentée par une alimentation électrique à une deuxième valeur de tension $V'CC_2$ égale à 5 V, par exemple. Dans ce cas-là et de manière semblable au mode de réalisation du convertisseur représenté en figure 3a, on indique que pour le mode de réalisation du convertisseur représenté en figure 3b, par convention, $V'CC_1 = VCC_2$ et $VCC_1 = V'CC_2$, valeurs des tensions représentées figures 1a et 1b respectivement.

Dans ce cas, la deuxième valeur de tension $V'CC_2$ est donc supérieure à la première valeur de tension. En outre, la première zone fonctionnelle délivre vers la deuxième zone fonctionnelle des signaux logiques d'entrée et des signaux logiques de commande, les signaux logiques d'entrée étant notés dans le cas de la figure 3b, $I'_1$ et les signaux logiques de commande étant notés $E'_1$. Ces signaux logiques ont bien entendu un niveau analogique adapté à la première valeur de tension d'alimentation, c'est-à-dire la valeur $V'CC_1 = 3$ V dans l'exemple de réalisation.

La deuxième zone fonctionnelle délivre vers la première zone fonctionnelle des signaux logiques de sortie notés $O'_2$, ces signaux logiques étant à un niveau analogique adapté à la deuxième valeur de tension $V'CC_2 = 5$ V dans l'exemple de réalisation.

Dans ces conditions, le convertisseur de niveaux analogiques des signaux logiques d'entrée, des signaux logiques de commande et des signaux logiques de sortie précédemment cités comprend au moins, ainsi que représenté en figure 3b, et interconnectés par rapport à une même tension de référence VSS, un premier circuit convertisseur de niveaux analogiques des signaux logiques d'entrée portant la référence 2B, ce circuit convertisseur 2B étant strictement identique au circuit convertisseur tel que représenté en figure 1b. Le premier circuit convertisseur de niveaux analogiques 2B reçoit des signaux logiques d'entrée, les signaux $I'_1$, constituant pour ce premier circuit convertisseur des premiers signaux d'entrée et délivre un premier signal logique d'entrée converti noté $I'_2$, dont le niveau analogique est bien entendu adapté à celui de la deuxième valeur de tension $V'CC_2$, c'est-à-dire dans l'exemple de réalisation donné, égal à 5 V.

De même, le convertisseur de niveau analogique représenté en figure 3b comprend un deuxième circuit convertisseur de niveaux analogiques, des signaux logiques de commande, ce deuxième circuit convertisseur portant la référence 2C sur la figure précitée.

Le deuxième circuit convertisseur 2C est strictement identique au circuit convertisseur 2B et au circuit convertisseur représenté en figure 1b. Le deuxième circuit convertisseur 2C reçoit les signaux logiques de commande notés $E'_1$, lesquels constituent, pour le convertisseur et pour ce deuxième circuit convertisseur 2C, des deuxièmes signaux d'entée à partir desquels le deuxième circuit convertisseur 2C délivre un deuxième signal logique de commande converti noté $E'_2$ dont le niveau analogique est adapté à celui de la deuxième valeur de tension $V'CC_2$, c'est-à-dire 5 V.

Enfin, le convertisseur de niveau analogique représenté en figure 3b comprend un troisième circuit convertisseur de niveaux analogiques portant la référence 1C permettant d'assurer la conversion des signaux logiques de sortie $O'_2$ délivrés par la deuxième zone fonctionnelle en signaux logiques de sortie $O'_1$ dont le niveau analogique est adapté à la tension d'alimentation de la première zone fonctionnelle, c'est-à-dire à la valeur $V'CC_1$ égale à 3 V.

On comprend ainsi que le convertisseur de niveaux analogiques représenté en figure 3b permet la conversion des signaux d'entrée $I'_1$ et des signaux de commande $E'_1$ d'un niveau logique bas à un niveau logique haut adapté à la tension d'alimentation de la deuxième zone fonctionnelle alors qu'au contraire, il permet en outre la conversion des signaux logiques de sortie $O'_2$ de la deuxième zone fonctionnelle d'un niveau logique haut à un niveau logique bas adapté à la valeur d'alimentation de la première zone fonctionnelle.

On comprend également que dans le cas du mode de réalisation du convertisseur tel que représenté en figure 3b, le signal $E'_1$ joue le rôle du signal $I'_1$ dans le cas du circuit convertisseur de la figure 1b et le signal $E'_2$ joue

le rôle du signal $I'_2$ de la même figure 1b.

La figure 4 représente un convertisseur configurable de niveaux analogiques des signaux logiques d'entrée, des signaux logiques de commande et des signaux logiques de sortie échangés entre la première et la deuxième valeur de tension alimentant la première et la deuxième zone fonctionnelle d'un circuit intégré tel qu'une mémoire à accès aléatoire ainsi que décrit précédemment dans la description.

Toutefois, selon un aspect particulièrement avantageux du convertisseur objet de la présente invention, la première zone fonctionnelle, constituée par exemple par l'ensemble des cellules mémoires et par une deuxième zone fonctionnelle formée par les circuits tampons précités, sont telles que la première zone fonctionnelle est alimentée par une alimentation électrique commutable entre une première et une deuxième valeur de tension, la deuxième valeur de tension étant inférieure, égale ou supérieure à la première valeur de tension, ces valeurs de tension étant notées $VCC_1$ et $VCC_2$, la deuxième zone fonctionnelle étant alimentée par une alimentation électrique également commutable entre ces premières et deuxièmes valeurs de tension précitées.

Sur la figure 4, on a représenté deux lignes d'alimentation notées A, B, lesquelles peuvent être portées au potentiel de la première respectivement deuxième valeur tension $VCC_1$, $VCC_2$ par l'intermédiaire d'un commutateur $IC_1$ et $IC_2$ respectivement.

La première zone fonctionnelle délivre vers la deuxième zone fonctionnelle des signaux logiques d'entrée et des signaux logiques de commande, ces signaux correspondant avec la même désignation aux signaux $I_1$ et $E_1$ de la figure 3a.

De la même manière, la deuxième zone fonctionnelle délivre vers la première zone fonctionnelle des signaux logiques de sortie $O_2$ portant la même référence que dans le cas de la figure 3a.

Un circuit comparateur C est prévu, lequel reçoit la valeur de la tension d'alimentation délivrée par les lignes A et B respectivement, le circuit comparateur C étant constitué, par exemple, par un comparateur de tension permettant de délivrer une variable logique notée Conf sur 2 bits permettant de représenter en fait l'état des commutateurs d'alimentation $IC_1$ et $IC_2$, c'est-à-dire la valeur des tensions $VCC_1$ ou $VCC_2$ présentes sur les lignes d'alimentation A et B.

A titre d'exemple non limitatif, on indique que lorsque la tension d'alimentation est la même sur les lignes A et B et égale soit à la première tension d'alimentation $VCC_1$, soit à la deuxième tension d'alimentation $VCC_2$, la variable logique Conf peut, par exemple, avoir la valeur 00. Au contraire, lorsque les tensions d'alimentation sur les lignes A et B ont des valeurs différentes, la variable logique Conf peut alors prendre la valeur 10, respectivement 01 ainsi que représentée a titre d'exemple non limitatif pour $VCC_1$ égale 5 V et $VCC_2$ égale 3 V dans le tableau 1 ci-après.

**Tableau 1 – Valeur de Conf en fonction de $V_A$, $V_B$**

| $V_B$ / $V_A$ | $VCC_1$ | $VCC_2$ |
|---|---|---|
| $VCC_1$ | 00 | 01 |
| $VCC_2$ | 10 | 00 |

Bien entendu, la variable logique Conf est délivrée à chaque interrupteur programmable précité par l'intermédiaire d'une liaison par bus à deux conducteurs, laquelle pour cette raison est représentée en pointillés sur la figure 4.

On comprend ainsi que le comparateur C, relié par la liaison par bus précitée aux interrupteurs programmables $I_{1O'2}$, $I_{E1E2}$, $I_{1I2}$, $IV_1$, $IV_2$ et $IV_{11}$ et $IV_{12}$ constituent ainsi des premiers éléments de commutation permettant par couplage d'appliquer, par exemple, aux premiers et deuxièmes circuits convertisseurs 1A et 1B le signal logique d'entrée $I_1$ pour le circuit convertisseur 1A, ce signal constituant les premiers signaux, ainsi que les signaux logiques de commande $E_1$ au deuxième circuit convertisseur 1B, constituant des deuxièmes signaux pour ce deuxième circuit convertisseur. Le premier circuit convertisseur 1A délivre alors, à partir des premiers signaux $I_1$, un premier signal logique d'entrée converti, c'est-à-dire le signal $I_2$, dont le niveau analogique est égal à celui de la deuxième valeur de tension. Au contraire, lorsque le signal de sortie $O'_2$ est appliqué à l'entrée du circuit convertisseur 1A, ce dernier délivre un signal de sortie converti $O'_1$, dont le niveau analogique est adapté à celui de la première valeur de tension alimentant la première zone fonctionnelle.

Le deuxième circuit convertisseur 1B délivre, à partir des deuxièmes signaux, c'est-à-dire du signal logique de commande $E_1$ un signal logique de commande converti $E_2$ dont le niveau analogique est égal à celui de la deuxième valeur de tension. Les signaux logiques de sortie $O'_2$ constituant les troisièmes signaux sont appliqués, par exemple, dans le cas de la figure 4, au premier convertisseur 1A par l'intermédiaire de l'interrupteur programmable $I_{11O'2}$.

Ainsi, le premier circuit convertisseur 1A et le deuxième circuit convertisseur 1B permettent de délivrer, en fonction de leur configuration, un signal de sortie converti dont le niveau analogique est égal à celui de la deuxième valeur de tension ou, pour ce qui concerne le circuit convertisseur 1A, lorsque celui-ci reçoit les signaux de sortie $O'2$ un signal converti à la première valeur de tension, c'est-à-dire le signal $O'_1$.

Le convertisseur configurable représenté en figure 4 comprend un troisième 2B et un quatrième 2C circuit convertisseur de niveaux analogiques de signaux logiques, ce troisième et ce quatrième circuit convertisseur étant strictement identiques aux circuits convertisseurs représentés en figure 1b. Le troisième circuit convertisseur 2B est alimenté par l'intermédiaire des interrupteurs programmables $IV_1$ et $IV_2$ respectivement.

Le quatrième circuit convertisseur 2C est alimenté à partir de ces mêmes interrupteurs programmables par les lignes A et B précitées par l'intermédiaire en outre d'interrupteurs programmables $IV_{21}$ et $IV_{22}$ respectivement.

Le troisième circuit convertisseur 2B reçoit par l'intermédiaire d'un interrupteur programmable $I_{I'1O2}$, soit le signal d'entrée $I'_1$, signal logique d'entrée délivré par la première zone fonctionnelle vers la deuxième zone fonctionnelle dans le cas de la figure 1b, ou au contraire le signal de sortie $O_2$ délivré par la deuxième zone fonctionnelle dans le cas de la figure 3a. Le troisième circuit convertisseur 2B délivre, en fonction du signal d'entrée, un signal logique converti correspondant soit au signal logique converti $I'_2$ de la figure 1b, soit au signal de sortie converti $O_1$ de la figure 3a. En outre, l'entrée de conversion du troisième circuit convertisseur 2A et la sortie de ce troisième circuit convertisseur sont reliées par l'intermédiaire d'un interrupteur programmable noté $I_{O1O2}$.

Le quatrième circuit convertisseur 2C reçoit sur son entrée de conversion le signal de commande $E'_1$ et délivre le signal de commande converti $E'_2$ ainsi que représenté sur la figure 3b. L'entrée de conversion et la sortie délivrant le signal logique converti sont reliées par l'intermédiaire d'un interrupteur programmable noté $I_{E'1E'2}$. Bien entendu, les interrupteurs programmables $I_{I'1O2}$, $I_{O1O2}$, $IV_{21}$, $IV_{22}$ et $I_{E'1E'2}$ sont reliés par la liaison par bus de façon à recevoir la variable logique de configuration Conf.

On comprend ainsi que le module de commutation C, associé aux interrupteurs programmables précités, constitue en fait un deuxième élément de commande de commutation permettant par couplage d'appliquer à l'un des troisième, respectivement quatrième circuits convertisseurs de niveau analogique de signaux logiques 2B et 2C les signaux logiques précités. Le troisième et le quatrième circuits convertisseurs 2B, 2C, délivrent, à partir de ces troisièmes signaux, un signal de sortie converti dont le niveau analogique est égal à celui de la première, respectivement de la deuxième valeur de tension. Les deuxièmes éléments de commande de commutation précités permettent également d'appliquer au troisième 2B et au quatrième circuit convertisseur 2C les signaux logiques d'entrée $I'_1$ constituant les premiers signaux, respectivement les signaux logiques de commande $E'_1$ constituant les deuxièmes signaux. Dans ces conditions, le troisième circuit convertisseur 2B délivre à partir des premiers signaux un premier signal logique d'entrée converti $I'2$ dont le niveau analogique est égal à celui de la deuxième valeur de tension alors que le quatrième circuit convertisseur 2C délivre, à partir des deuxièmes signaux, c'est-à-dire du signal de commande $E'_1$ le signal logique de commande converti $E'_2$ dont le niveau analogique est égal à celui de la deuxième valeur de tension.

On comprend bien sûr qu'en ce qui concerne les interrupteurs programmables $I_{I1I2}$, $I_{E1E2}$, $I_{O1O2}$, $I_{E'1E'2}$, ces derniers, en position normalement ouverte lorsque les tensions sur les lignes d'alimentation A et B sont différentes, sont amenées en position fermée lorsque les tensions d'alimentation sur les lignes A et B sont identiques de façon à permettre la transmission directe des signaux logiques d'entrée vers la sortie, chaque circuit de conversion 1A, 1B, 2B et 2C étant alors court-circuité de façon à permettre la transmission directe en l'absence de toute conversion de niveaux analogiques des signaux logiques émis par l'une des zones fonctionnelles vers l'autre zone fonctionnelle en raison du fait que les tensions d'alimentation de ces dernières sont identiques. Dans le cas précité, on indique que grâce à la mise en oeuvre des interrupteurs $IV_1$, $IV_2$, $IV_{11}$, $IV_{12}$, $IV_{21}$ et $IV_{22}$, les circuits de conversion 1A, 1B et 2B, 2C sont alors déconnectés des lignes d'alimentation, ce qui permet de réduire la consommation globale du circuit intégré correspondant.

Un tableau, tableau 2, donnant les valeurs de position des interrupteurs programmables en fonction de la variable logique de configuration Conf est donné ci-après, la valeur 0 indiquant la position ouverte de l'interrupteur programmable et la valeur 1 indiquant sa position fermée.

Tableau 2

| Conf | $IV_1$ | $IV_2$ | $IV_{11}$ | $IV_{12}$ | $IV_{21}$ | $IV_{22}$ | $I_{I1O'2}$ | $I_{I1I2}$ | $I_{E1E2}$ | $I_{E'1E'2}$ | $I'_{I1O2}$ | $I_{O1O2}$ |
|---|---|---|---|---|---|---|---|---|---|---|---|---|
| 00 | 0 | 0 | 0 | 0 | 0 | 0 | 1 | 1 | 1 | 1 | 1 | 1 |
| 01 | 1 | 1 | 1 | 1 | 0 | 0 | 1 | 0 | 0 | 0 | 0 | 0 |
| 10 | 1 | 1 | 0 | 0 | 1 | 1 | 0 | 0 | 0 | 0 | 0 | 0 |

On comprend en particulier que grâce à la mise en oeuvre d'une part des interrupteurs $IC_1$ et $IC_2$ permettant la commutation d'une valeur de tension à une autre valeur de tension et du comparateur C associé aux interrupteurs programmables précédemment cités, ces éléments de commutation constituent, associés au comparateur C, un élément de gestion des premiers et deuxièmes éléments de commutation. On comprend ainsi que ces éléments de gestion permettent en fait de reconstituer la configuration de la figure 3a ou de la figure 3b en connectant trois des circuits convertisseurs 1A, 1B et 28, 2C de la figure 4a parmi les quatre circuits convertisseurs implantés, sur critères d'exclusion du couplage simultané du premier, du deuxième, du troisième et du quatrième circuits convertisseurs de niveaux analogiques précités, et de couplage de trois convertisseurs parmi quatre pour assurer, soit la conversion niveau analogique haut - niveau analogique haut et réciproquement, entre première zone fonctionnelle et deuxième zone fonctionnelle par couplage du premier, du deuxième et de l'un des troisième ou quatrième circuits convertisseurs, soit au contraire la conversion niveau analogique bas - niveau analogique bas et réciproquement entre la première zone fonctionnelle et la deuxième zone fonctionnelle, par couplage de l'un des premier ou deuxième circuits convertisseurs et des troisième et quatrième circuits convertisseurs lorsque les tensions d'alimentation sur les lignes d'alimentation A et B sont différentes. Lorsqu'au contraire, les tensions d'alimentation sur les lignes d'alimentation A et B sont identiques, la conversion entre même niveau logique haut respectivement bas peut être réalisée par simple transmission grâce à la mise en oeuvre des interrupteurs programmables de court-circuits précédemment cités dans la description. Selon un aspect particulièrement avantageux du convertisseur configurable représenté en figure 4, on indique que lorsque les tensions d'alimentation sur les lignes d'alimentation A et B sont identiques, les interrupteurs $I_{I1I2}$, $I_{E1E2}$, $I_{O1O2}$ et $I_{E'1E'2}$ peuvent sans inconvénient être maintenus à l'état ouvert, car chaque convertisseur 1A, 1B, 2B ou 2C assure le processus de conversion de manière totalement transparente. Cette configuration peut alors être obtenue au moyen de la valeur spécifique de la variable de configuration Conf = 11, laquelle permet la commande des interrupteurs précités en conséquence. A cet effet, le comparateur C peut alors être muni d'une commande d'entrée T, à l'initiative de l'utilisateur, permettant à ce dernier de sélectionner le fonctionnement en mode transparent.

On comprend ainsi que le convertisseur configurable objet de la présente invention, tel que représenté en figure 4, apparaît particulièrement adapté à une utilisation sur des circuits intégrés dans lesquels la configuration de l'alimentation est réalisée par l'intermédiaire des interrupteurs $IC_1$ et $IC_2$ en fonction du matériel disponible. Une application particulièrement avantageuse concerne notamment les circuits mémoire aléatoire pour micro-ordinateurs portables dans lesquels il est avantageux, en fonction de l'application considérée, de privilégier soit la vitesse d'exécution, c'est-à-dire de lecture de la mémoire aléatoire, au prix toutefois d'une consommation importante, soit au contraire l'autonomie de fonctionnement de ces circuits au prix toutefois d'une vitesse plus lente. On comprend en particulier que dans cette application les interrupteurs $IC_1$ et $IC_2$ peuvent également être constitués par des interrupteurs programmables, commandés au gré de l'utilisateur de l'ordinateur portable.

**Revendications**

1.  Circuit convertisseur de niveaux analogiques de premiers signaux logiques d'une première zone fonctionnelle d'un circuit intégré, alimentée par une alimentation électrique à une première valeur de tension ($Vcc_1$), en deuxièmes signaux logiques d'une deuxième zone fonctionnelle de ce circuit intégré, alimentée par une alimentation électrique à une deuxième valeur de tension ($Vcc_2$), supérieure ou égale à la première valeur de tension, ces valeurs de tension étant définies par rapport à une même tension de référence, ce circuit convertisseur comportant, successivement connectés en cascade, par rapport à ladite tension de référence commune :

    -   un étage inverseur (20) alimenté à la première valeur de tension, recevant sur une borne d'entrée un signal logique d'entrée constitué par lesdits premiers signaux dont le niveau analogique est adapté à celui de la première valeur de tension et délivrant un signal logique d'entrée inversé, et
    -   des moyens convertisseurs amplificateurs (21) alimentés à la deuxième valeur de tension, connectés audit étage inverseur et délivrant, par amplification, un signal logique de sortie converti en phase avec le signal logique d'entrée et dont le niveau analogique est adapté à celui de la deuxième valeur de tension et qui constitue lesdits deuxièmes signaux logiques,

**caractérisé en ce que** lesdits moyens convertisseurs amplificateurs (21) comportent :

· un premier étage inverseur ($TN_2$, $TP_2$) interconnecté à ladite deuxième valeur de tension par l'intermédiaire d'un transistor de réaction ($TP_3$), recevant ledit signal logique d'entrée et délivrant un signal logique d'entrée inversé à un niveau analogique sensiblement égal à celui de la deuxième valeur de tension ;
· un deuxième étage inverseur ($TN_4$, $TP_4$) recevant sur une borne d'entrée ledit signal logique d'entrée inversé délivré par le premier étage inverseur ;
· un transistor de commande cumulative ($TN_3$) connecté entre la deuxième valeur de tension et l'entrée du deuxième étage inverseur, l'électrode de grille du transistor de commande cumulative étant reliée en sortie de l'étage inverseur (20) alimenté par la première valeur de tension, ledit deuxième étage inverseur ($TN_4$, $TP_4$) délivrant sur une sortie un signal logique d'entrée dupliqué à un niveau analogique adapté à celui de la deuxième valeur de tension, ladite sortie étant interconnectée en réaction à l'électrode de grille dudit transistor de réaction ($TP_3$);
· un troisième étage inverseur ($TN_5$,$TP_5$) recevant ledit signal logique d'entrée dupliqué et délivrant un signal logique d'entrée inversé calibré ;
· un quatrième étage inverseur ($TN_6$,$TP_6$) recevant ledit signal logique d'entrée inversé calibré et délivrant ledit signal logique de sortie converti en phase avec le signal logique d'entrée et dont le niveau analogique est adapté à celui de la deuxième valeur de tension.

2. Circuit intégré de type mémoire à accès aléatoire comportant une première zone fonctionnelle constituée par un ensemble de cellules mémoires, et par une deuxième zone fonctionnelle constituée par des circuits tampons, ces cellules mémoires étant accessibles par l'intermédiaire de ces circuits tampons, ladite première zone fonctionnelle étant alimentée par une alimentation électrique à une première valeur de tension et ladite deuxième zone fonctionnelle étant alimentée par une alimentation électrique à une deuxième valeur de tension, inférieure ou égale à la première valeur de tension, ladite première zone fonctionnelle délivrant vers ladite deuxième zone fonctionnelle des signaux logiques d'entrée et des signaux logiques de commande à un niveau analogique adapté à la première valeur de tension et ladite deuxième zone fonctionnelle délivrant vers ladite première zone fonctionnelle des signaux logiques de sortie à un niveau analogique adapté à la deuxième valeur de tension,
caractérisé en en ce qu'il comporte en outre un convertisseur de niveaux analogiques des signaux logiques d'entrée, des signaux logiques de commande et des signaux logiques de sortie, ledit convertisseur comprenant au moins, interconnectés par rapport à une même tension de référence :

- un premier circuit convertisseur de niveaux analogiques des signaux logiques d'entrée, lesdits signaux logiques d'entrée constituant pour ce premier circuit convertisseur des premiers signaux, ledit premier circuit convertisseur délivrant, à partir de ces premiers signaux, un premier signal logique d'entrée converti dont le niveau analogique est adapté à celui de la deuxième valeur de tension ;
- un deuxième circuit convertisseur de niveaux analogiques des signaux logiques de commande, lesdits signaux logiques de commande constituant pour ce deuxième circuit convertisseur des deuxièmes signaux, ledit deuxième circuit convertisseur délivrant, à partir de ces deuxièmes signaux, un deuxième signal logique de commande converti dont le niveau analogique est adapté à celui de la deuxième valeur de tension ;
- et un troisième circuit convertisseur de niveaux analogiques des signaux logiques de sortie selon la revendication 1, lesdits signaux logiques de sortie constituant pour ce troisième convertisseur des troisièmes signaux, ledit troisième circuit convertisseur délivrant, à partir de ces troisièmes signaux, un signal logique de sortie converti dont le niveau analogique est adapté à celui de la première valeur de tension.

3. Circuit intégré de type mémoire à accès aléatoire comportant une première zone fonctionnelle constituée par un ensemble de cellules mémoires, et par une deuxième zone fonctionnelle constituée par des circuits tampons, ces cellules mémoires étant accessibles par l'intermédiaire de ces circuits tampons, ladite première zone fonctionnelle étant alimentée par une alimentation électrique à une première valeur de tension et ladite deuxième zone fonctionnelle étant alimentée par une alimentation électrique à une deuxième valeur de tension, supérieure ou égale à la première valeur de tension, ladite première zone fonctionnelle délivrant vers ladite deuxième zone fonctionnelle des signaux logiques d'entrée et des signaux logiques de commande à un niveau analogique adapté à la première valeur de tension et ladite deuxième zone fonctionnelle délivrant vers ladite première zone fonctionnelle des signaux logiques de sortie à un niveau analogique adapté à la deuxième valeur de tension,
**caractérisé en ce qu'**il comporte en outre un convertisseur de niveaux analogiques des signaux logiques d'entrée, des signaux logiques de commande et des signaux logiques de sortie, ledit convertisseur comprenant au moins, interconnectés par rapport à une même tension de référence :

- un premier circuit convertisseur de niveaux analogiques des signaux logiques d'entrée, selon la revendication 1, lesdits signaux logiques d'entrée constituant pour ce premier circuit convertisseur des premiers signaux, ledit premier circuit convertisseur délivrant, à partir de ces premiers signaux, un premier signal logique d'entrée converti dont le niveau analogique est adapté à celui de la deuxième valeur de tension ;
- un deuxième circuit convertisseur de niveaux analogiques des signaux logiques de commande, selon la revendication 1, lesdits signaux logiques de commande constituant pour ce deuxième circuit convertisseur des deuxièmes signaux, ledit deuxième circuit convertisseur délivrant à partir de ces deuxièmes signaux un deuxième signal logique de commande converti dont le niveau analogique est adapté à celui de la deuxième valeur de tension ;
- un troisième circuit convertisseur de niveaux analogiques des signaux logiques de sortie, lesdits signaux logiques de sortie constituant pour ce troisième circuit convertisseur des troisièmes signaux, ledit troisième circuit convertisseur délivrant, à partir de ces troisièmes signaux, un signal logique de sortie converti, dont le niveau analogique est adapté à celui de la première valeur de tension.

4. Circuit intégré de type mémoire à accès aléatoire comportant une première zone fonctionnelle constituée par un ensemble de cellules mémoires, et par une deuxième zone fonctionnelle formée par des circuits tampons, ces cellules mémoires étant accessibles par l'intermédiaire de ces circuits tampons, ladite première zone fonctionnelle étant alimentée par une alimentation électrique commutable entre une première et une deuxième valeur de tension, ladite deuxième valeur de tension étant inférieure, égale ou supérieure à la première valeur de tension et ladite deuxième zone fonctionnelle étant alimentée par une alimentation électrique commutable entre lesdites première et deuxième valeurs de tension, ladite première zone fonctionnelle délivrant vers ladite deuxième zone fonctionnelle des signaux logiques d'entrée et des signaux logiques de commande à un niveau analogique adapté à la première respectivement la deuxième valeur de tension, et ladite deuxième zone fonctionnelle délivrant vers ladite première zone fonctionnelle des signaux logiques de sortie à un niveau analogique adapté à la première respectivement la deuxième valeur de tension,
**caractérisé en ce qu'**il comporte un convertisseur configurable de niveau analogique des signaux logiques d'entrée, des signaux logiques de commande et des signaux logiques de sortie entre les niveaux analogiques de la première et de la deuxième valeur de tension comprenant au moins, par rapport à une même tension de référence :

- un premier et un deuxième circuit convertisseur de niveaux analogiques des signaux logiques, ces signaux logiques étant constitués par lesdits signaux logiques d'entrée, lesdits signaux logiques de commande et lesdits signaux logique de sortie ;
- un troisième et un quatrième circuit convertisseur de niveaux analogiques de signaux logiques selon la revendication 1, ces signaux logiques étant constitués par lesdits signaux logiques d'entrée, lesdits signaux logiques de commande et lesdits signaux logiques de sortie ;
- des premiers et des deuxièmes moyens de commutation permettant d'appliquer par couplage, soit aux premier et deuxième circuits convertisseurs, respectivement à l'un des troisième respectivement l'un des quatrième circuits convertisseurs de signaux logiques d'entrée et des signaux logiques de commande, respectivement des signaux logiques de sortie pour délivrer un signal logique de sortie converti dont le niveau analogique est adapté à celui de la première respectivement deuxième valeur de tension, soit aux troisième et deuxième circuits convertisseurs, respectivement à l'un des premier respectivement deuxième circuits convertisseurs des signaux logiques d'entrée et des signaux logiques de commande respectivement des signaux logiques de sortie pour délivrer un signal logique de sortie converti dont le niveau analogique est adapté à celui de la deuxième respectivement première valeur de tension ;
- des moyens de gestion des premiers et des deuxièmes moyens de commutation, sur critère d'exclusion du couplage simultané du premier, du deuxième, du troisième et du quatrième circuit convertisseur de niveaux analogiques et du couplage de trois convertisseurs parmi quatre pour assurer, soit la conversion niveau analogique haut/niveau analogique bas et réciproquement entre première zone fonctionnelle et deuxième zone fonctionnelle par couplage du premier, du deuxième et de l'un des troisième respectivement quatrième circuits convertisseurs, soit la conversion niveau analogique bas/niveau analogique haut et réciproquement entre la première zone fonctionnelle et deuxième zone fonctionnelle par couplage de l'un des premier respectivement deuxième et des troisième et quatrième circuits convertisseurs, ou encore une conversion entre même niveau analogique haut respectivement bas en fonction de la valeur relative de la première et de la deuxième valeur de tension.

**Patentansprüche**

1. Konverterschaltung für analoge Pegel, welche erste logische Signale eines ersten funktionellen Bereiches einer integrierten Schaltung, wobei dieser erste Bereich durch eine Stromversorgung mit einem ersten Spannungswert ($Vcc_1$) versorgt wird, in zweite logische Signale eines zweiten funktionellen Bereichs dieser integrierten Schaltung umwandelt, wobei dieser zweite Bereich durch eine Stromversorgung mit einem zweiten Spannungswert ($Vcc_2$), der höher als oder gleich dem ersten Spannungswert ist, versorgt wird, wobei die Spannungswerte in Bezug auf ein und dieselbe Referenzspannung definiert werden, wobei die Konverterschaltung in Bezug auf die gemeinsame Referenzspannung nacheinander in Kaskadenschaltung verbunden Folgendes umfasst:

   - eine Inverterstufe (20), die mit dem ersten Spannungswert versorgt wird und die auf einer Eingangsklemme ein logisches Eingangssignal empfängt, das aus den ersten Signalen besteht, deren analoger Pegel an jenen des ersten Spannungswertes angepasst ist, und die ein umgekehrtes logisches Eingangssignal bereitstellt, und

   - verstärkende Konvertermittel (21), welche mit dem zweiten Spannungswert versorgt werden und die mit der Inverterstufe verbunden sind und durch Verstärkung ein logisches Ausgangssignal bereitstellen, das mit dem logischen Eingangssignal gleichphasig umgewandelt wird und dessen analoger Pegel an jenen des zweiten Spannungswertes angepasst ist, und welches die zweiten logischen Signale darstellt,

   **dadurch gekennzeichnet, dass** die verstärkenden Konvertermittel (21) Folgendes umfassen:

   - eine erste Inverterstufe ($TN_2$, $TP_2$), die mit dem zweiten Spannungswert über einen Reaktionstransistor ($TP_3$) verbunden ist, welcher das logische Eingangssignal empfängt und ein umgekehrtes logisches Ausgangssignal mit einem analogen Pegel bereitstellt, der im wesentlichen gleich jenem des zweiten Spannungswertes ist;

   - eine zweite Inverterstufe ($TN_4$, $TP_4$), welche auf einer Eingangsklemme das umgekehrte logische Eingangssignal empfängt, das von der ersten Inverterstufe bereitgestellt wird;

   - einen Transistor für kumulative Befehle ($TN_3$), der zwischen dem zweiten Spannungswert und dem Eingang der zweiten Inverterstufe geschaltet ist, wobei die Steuerelektrode des Transistors für kumulative Befehle am Ausgang der Inverterstufe (20) angeschlossen ist, welche durch den ersten Spannungswert versorgt wird, wobei die zweite Inverterstufe ($TN_4$, $TP_4$) auf einem Ausgang ein dupliziertes logisches Eingangssignal mit einem analogen Pegel bereitstellt, der an jenen des zweiten Spannungswertes angepasst ist, wobei der Ausgang in Reaktion an die Steuerelektrode des Reaktionstransistors ($TP_3$) zwischengeschaltet ist;

   - eine dritte Inverterstufe ($TN_5$, $TP_5$), welche das duplizierte logische Eingangssignal empfängt und ein umgekehrtes, kalibriertes logisches Eingangssignal bereitstellt;

   - eine vierte Inverterstufe ($TN_6$, $TP_6$), welche das umgekehrte, kalibrierte logische Eingangssignal empfängt und das logische Ausgangssignal bereitstellt, das mit dem logischen Eingangssignal gleichphasig umgewandelt ist und dessen analoger Pegel an jenen des zweiten Spannungswertes angepasst ist.

2. Integrierte Schaltung mit einem Speicher mit wahlfreiem Zugriff, welche einen ersten funktionellen Bereich, der aus einer Anordnung von Speicherzellen besteht, und einen zweiten funktionellen Bereich umfasst, der aus Pufferschaltungen besteht, wobei die Speicherzellen über die Pufferschaltungen zugänglich sind, wobei der erste funktionelle Bereich durch eine Stromversorgung mit einem ersten Spannungswert versorgt wird und der zweite funktionelle Bereich durch eine Stromversorgung mit einem zweiten Spannungswert versorgt wird, der niedriger als oder gleich dem ersten Spannungswert ist, wobei der erste funktionelle Bereich für den zweiten funktionellen Bereich logische Eingangssignale und logische Steuersignale mit einem analogen Pegel bereitstellt, der an den ersten Spannungswert angepasst ist, und wobei der zweite funktionelle Bereich für den ersten funktionellen Bereich logische Ausgangssignale mit einem analogen Pegel bereitstellt, der an den zweiten Spannungswert angepasst ist,
   **dadurch gekennzeichnet, dass** die Schaltung ferner einen Konverter für analoge Pegel von logischen Eingangssignalen, logischen Steuersignalen und logischen Ausgangssignalen umfasst, wobei der Konverter zwischengeschaltet in Bezug auf eine gemeinsame Referenzspannung mindestens Folgendes umfasst:

   - eine erster Konverterschaltung für analoge Pegel von logischen Eingangssignalen, wobei die logischen Eingangssignale für die erste Konverterschaltung erste Signale darstellen, wobei die erste Konverterschaltung ausgehend von diesen ersten Signalen ein umgewandeltes erstes logisches Eingangssignal bereitstellt, dessen analoger Pegel an jenen des zweiten Spannungswertes angepasst ist;

- eine zweite Konverterschaltung für analoge Pegel von logischen Steuersignalen, wobei die logischen Steuersignale für diese zweite Konverterschaltung zweite Signale darstellen, wobei die zweite Konverterschaltung ausgehend von diesen zweiten Signalen ein umgewandeltes zweites logisches Steuersignal bereitstellt, dessen analoger Pegel an jenen des zweiten Spannungswertes angepasst ist;

- und eine dritte Konverterschaltung für analoge Pegel von logischen Ausgangssignalen nach Anspruch 1, wobei die logischen Ausgangssignale für diesen dritten Konverter dritte Signale darstellen, wobei die dritte Konverterschaltung ausgehend von diesen dritten Signalen ein umgewandeltes logisches Ausgangssignal bereitstellt, dessen analoger Pegel an jenen des ersten Spannungswertes angepasst ist.

3. Integrierte Schaltung mit einem Speicher mit wahlfreiem Zugriff, welche einen ersten funktionellen Bereich, der aus einer Anordnung von Speicherzellen besteht, und einen zweiten funktionellen Bereich umfasst, der aus Pufferschaltungen besteht, wobei die Speicherzellen über die Pufferschaltungen zugänglich sind, wobei der erste funktionelle Bereich durch eine Stromversorgung mit einem ersten Spannungswert und der zweite funktionelle Bereich durch eine Stromversorgung mit einem zweiten Spannungswert versorgt wird, der höher als oder gleich dem ersten Spannungswert ist, wobei der erste funktionelle Bereich für den zweiten funktionellen Bereich logische Eingangssignale und logische Steuersignale mit einem analogen Pegel bereitstellt, der an den ersten Spannungswert angepasst ist, und wobei der zweite funktionelle Bereich für den ersten funktionellen Bereich logische Ausgangssignale mit einem analogen Pegel bereitstellt, der an den zweiten Spannungswert angepasst ist, **dadurch gekennzeichnet, dass** die Schaltung ferner einen Konverter für analoge Pegel von logischen Eingangssignalen, logischen Steuersignalen und logischen Ausgangssignalen umfasst, wobei der Konverter in Bezug auf ein und dieselbe Referenzspannung zwischengeschaltet Folgendes umfasst:

- eine erste Konverterschaltung für analoge Pegel von logischen Eingangssignalen nach Anspruch 1, wobei die logischen Eingangssignale für die erste Konverterschaltung erste Signale darstellen, wobei die erste Konverterschaltung ausgehend von den ersten Signalen ein erstes umgewandeltes logisches Eingangssignal bereitstellt, dessen analoger Pegel an jenen des zweiten Spannungswertes angepasst ist;

- eine zweite Konverterschaltung für analoge Pegel von logischen Steuersignalen nach Anspruch 1, wobei die logischen Steuersignale für die zweite Konverterschaltung zweite Signale darstellen, wobei die zweite Konverterschaltung ausgehend von den zweiten Signalen ein zweites umgewandeltes logisches Steuersignal bereitstellt, dessen analoger Pegel an jenen des zweiten Spannungswertes angepasst ist;

- eine dritte Konverterschaltung für analoge Pegel von logischen Ausgangssignalen, wobei die logischen Ausgangssignale für die dritte Konverterschaltung dritte Signale darstellen, wobei die dritte Konverterschaltung ausgehend von den dritten Signalen ein umgewandeltes logisches Ausgangssignal bereitstellt, dessen analoger Pegel an jenen des ersten Spannungswertes angepasst ist.

4. Integrierte Schaltung mit einem Speicher mit wahlfreiem Zugriff, welche einen ersten funktionellen Bereich, der aus einer Anordnung von Speicherzellen besteht, und einen zweiten funktionellen Bereich umfasst, welcher durch die Pufferschaltungen gebildet ist, wobei die Speicherzellen über die Pufferschaltungen zugänglich sind, wobei der erste funktionelle Bereich durch eine Stromversorgung versorgt wird, die zwischen einem ersten und einem zweiten Spannungswert umgeschaltet werden kann, wobei der zweite Spannungswert geringer als, gleich oder größer als der erste Spannungswert ist, und wobei der zweite funktionelle Bereich durch eine Stromversorgung versorgt wird, die zwischen dem ersten und dem zweiten Spannungswert umgeschaltet werden kann, wobei der erste funktionelle Bereich für den zweiten funktionellen Bereich logische Eingangssignale und logische Steuersignale mit einem analogen Pegel bereitstellt, der an den ersten bzw. den zweiten Spannungswert angepasst ist, und wobei der zweite funktionelle Bereich für den ersten funktionellen Bereich logische Ausgangssignale mit einem analogen Pegel bereitstellt, der an den ersten bzw. den zweiten Spannungswert angepasst ist, **dadurch gekennzeichnet, dass** die Schaltung einen konfigurierbaren Konverter für analoge Pegel von logischen Eingangssignalen, logischen Steuersignalen und logischen Ausgangsignalen zwischen den analogen Pegeln des ersten und des zweiten Spannungswertes umfasst, der in Bezug auf ein und dieselbe Referenzspannung mindestens Folgendes umfasst:

- eine erste und eine zweite Konverterschaltung für analoge Pegel von logischen Signalen, wobei die logischen Signale durch die logischen Eingangssignale, logischen Steuersignale und logischen Ausgangssignale gebildet werden;

- eine dritte und eine vierte Konverterschaltung für analoge Pegel von logischen Signalen nach Anspruch 1, wobei die logischen Signale aus den logischen Eingangssignalen, den logischen Steuersignalen und logischen Ausgangssignalen bestehen;

- erste und zweite Umschaltmittel, welche es ermöglichen, durch Kopplung entweder auf die ersten und die zweiten Konverterschaltungen bzw. an eine der dritten bzw. eine der vierten Konverterschaltungen logische Eingangssignale und logische Steuersignale bzw. logische Ausgangssignale anzulegen, um ein umgewandeltes logisches Ausgangssignal bereitzustellen, dessen analoger Pegel an jenen des ersten bzw. zweiten Spannungswertes angepasst ist, oder an die dritten und zweiten Konverterschaltungen bzw. an eine der ersten bzw. zweiten Konverterschaltungen logische Eingangssignale und logische Steuersignale bzw. logische Ausgangssignale anzulegen, um ein umgewandeltes logisches Ausgangssignal bereitzustellen, dessen analoger Pegel an jenen des zweiten bzw. ersten Spannungswertes angepasst ist;

- Mittel zum Verwalten der ersten und der zweiten Umschaltmittel, mit dem Ausschlusskriterium der gleichzeitigen Kopplung der ersten, der zweiten, der dritten und der vierten Konverterschaltung für analoge Pegel und der Kopplung von drei der vier Konverter, um entweder die Umwandlung von hohem analogem Pegel zu niedrigem analogem Pegel und umgekehrt zwischen dem ersten funktionellen Bereich und dem zweiten funktionellen Bereich durch Kopplung der ersten, der zweiten und einer der dritten bzw. der vierten Konverterschaltungen oder die Umwandlung von niedrigem analogem Pegel zu hohem analogem Pegel und umgekehrt zwischen dem ersten funktionellen Bereich und dem zweiten funktionellen Bereich durch Kopplung von einem der ersten bzw. der zweiten und der dritten und der vierten Konverterschaltungen, oder eine Umwandlung zwischen gleich hohen bzw. gleich niedrigen analogen Pegeln in Abhängigkeit vom relativen Wert des ersten und des zweiten Spannungswertes zu gewährleisten.

## Claims

1. Circuit for converting analog levels of first logic signals of a first functional area of an integrated circuit, this area being supplied from an electrical supply at a first voltage value (Vcc1), into second logic signals of a second functional area of this integrated circuit, this area being supplied from an electrical supply at a second voltage value (Vcc2), higher than or equal to the first voltage value, these values being defined with respect to the same reference voltage, the converting circuit comprising, connected in succession in cascade with respect to said common reference voltage:

   - an inverter stage (20) connected to the first voltage value, receiving on an input terminal a logic input signal consisting of said first signals whose analog level is adapted to that of the first voltage value and delivering an inverted logic input signal, and
   - amplifying converter means (21) supplied at the second voltage value, connected to said inverter stage and delivering, via amplification, a converted logic output signal converted in phase to that of the input logic signal and the analog level of which is adapted to the second voltage value, and which constitute said second logic signals,

   **characterized in that** said differential converter means (21) comprise:

   - a first inverter stage ($TN_2$,$TP_2$) interconnected with said second voltage value by way of a feedback transistor ($TP_3$), receiving said logic input signal and delivering an inverted logic input signal at an analog level substantially equal to that of the second voltage value;
   - a second inverter stage ($TN_4$, $TP_4$) receiving on an input terminal said inverted logic input signal delivered by the first inverter stage;
   - a cumulative control transistor ($TN_3$) connected between the second voltage value and the input of the second inverter stage, the gate electrode of the cumulative control transistor being linked to the output of the inverter stage (20) supplied with the first voltage value, said second inverter stage ($TN_4$, $TP_4$) delivering on an output a replicated logic input signal at an analog level adapted to that of the second voltage value, said output being feedback-inter-connected with the gate electrode of said feedback transistor ($TP_3$);

- a third inverter stage (TN$_5$, TP$_5$) receiving said replicated logic input signal and delivering a calibrated inverted logic input signal;
- a fourth inverter stage (TN$_6$, TP$_6$) receiving said calibrated inverted logic input signal and delivering said converted logic output signal in phase with the logic input signal and whose analog level is adapted to that of the second voltage value.

2. Integrated circuit of random access memory type comprising a first functional area consisting of a set of memory cells, and of a second functional area consisting of buffer circuits, these memory cells being accessible by way of these buffer circuits, said first functional area being supplied from an electrical supply at a first voltage value and said second functional area being supplied from an electrical supply at a second voltage value, less than or equal to the first voltage value, said first functional area delivering to said second functional area logic input signals and logic control signals at an analog level adapted to the first voltage value and said second functional area delivering to said first functional area logic output signals at an analog level adapted to the second voltage value, **characterized in that** it further comprises a converter of analog levels of the logic input signals, of the logic control signals and of the logic output signals, said converter comprising at least, interconnected with respect to the same reference voltage:

- a first circuit for converting analog levels of the logic input signals, said logic input signals constituting first signals in respect of this first converter circuit, said first converter circuit delivering, on the basis of these first signals, a first converted logic input signal whose analog level is adapted to that of the second voltage value;
- a second circuit for converting analog levels of the logic control signals, said logic control signals constituting second signals in respect of this second converter circuit, said second converter circuit delivering, on the basis of these second signals, a second converted logic control signal whose analog level is adapted to that of the second voltage value;
- a third circuit for converting analog levels of the logic output signals according to claim 1, said logic output signals constituting third signals in respect of this third converter, said third converter circuit delivering, on the basis of these third signals, a converted logic output signal whose analog level is adapted to that of the first voltage value.

3. Integrated circuit of random access memory type comprising a first functional area consisting of a set of memory cells, and of a second functional area consisting of buffer circuits, these memory cells being accessible by way of these buffer circuits, said first functional area being supplied from an electrical supply at a first voltage value and said second functional area being supplied from an electrical supply at a second voltage value, greater than or equal to the first voltage value, said first functional area delivering to said second functional area, logic input signals and logic control signals at an analog level adapted to the first voltage value and said second functional area delivering to said first functional area, logic output signals at an analog level adapted to the second voltage value, **characterized in that** it further comprises a converter of analog levels of the logic input signals, of the logic control signals and of the logic output signals, said converter comprising at least, interconnected with respect to the same reference voltage:

- a first circuit for converting analog levels of the logic input signals, according to Claim 1, said logic input signals constituting first signals in respect of this first converter circuit, said first converter circuit delivering, on the basis of these first signals, a first converted logic input signal whose analog level is adapted to that of the second voltage value;
- a second circuit for converting analog levels of the logic control signals, according to Claim 1, said logic control signals constituting second signals in respect of this second converter circuit, said second converter circuit delivering, on the basis of these second signals, a second converted logic control signal whose analog level is adapted to that of the second voltage value;
- a third circuit for converting analog levels of the logic output signals, said logic output signals constituting third signals in respect of this third converter circuit, said third converter circuit delivering, on the basis of these third signals, a converted logic output signal whose analog level is adapted to that of the first voltage value.

4. Integrated circuit of random access memory type comprising a first functional area consisting of a set of memory cells, and of a second functional area formed by buffer circuits, these memory cells being accessible by way of these buffer circuits, said first functional area being supplied from an electrical supply which can be switched between a first and a second voltage value, said second voltage value being less than, equal to or greater than the first voltage value and said second functional area being supplied from an electrical supply which can be switched between said first and second voltage values, said first functional area delivering to said second functional area, logic input signals and logic control signals at an analog level adapted to the first respectively the second voltage value, and said second functional area delivering to said first functional area, logic output signals at an analog level adapted to the first respectively the second voltage value,

**characterized in that** it comprises a configurable converter for converting the analog level of the logic input signals, of the logic control signals and of the logic output signals between the analog levels of the first and of the second voltage value comprising at least, with respect to the same reference voltage:

- a first and a second circuit for converting analog levels of the logic signals, these logic signals consisting of said logic input signals, said logic control signals and said logic output signals;
- a third and a fourth circuit for converting analog levels of logic signals according to Claim 1, these logic signals consisting of said logic input signals, said logic control signals and said logic output signals;
- first and second switching means making it possible to apply by coupling, either to the first and second converter circuits, respectively to one of the third respectively to one of the fourth circuits for converting logic input signals and logic control signals, respectively logic output signals in order to deliver a converted logic output signal whose analog level is adapted to that of the first respectively second voltage value, or to the third and second converter circuits, respectively to one of the first respectively second circuits for converting the logic input signals and the logic control signals respectively the logic output signals in order to deliver a converted logic output signal whose analog level is adapted to that of the second respectively first voltage value;
- means for managing the first and second switching means, upon a criteria of exclusion of the simultaneous coupling of the first, of the second, of the third and of the fourth circuit for converting analog levels and of the coupling of three out of four converters so as to effect, either the high analog level/low analog level conversion and vice versa between first functional area and second functional area by coup ling of the first, of the second and of one of the third respectively fourth converter circuits, or the low analog level/high analog level conversion and vice versa between the first functional area and second functional area by coupling of one of the first respectively second and of the third and fourth converter circuits, or else a conversion between the same high respectively low analog level as a function of the relative value of the first and of the second voltage value.

FIG.1o.
(ART ANTÉRIEUR)

FIG.1a.

$Vcc_2 \leqslant Vcc_1$

FIG.1b.

$V'cc_2 \geqslant V'cc_1$

FIG.2

FIG.3a.

$\begin{cases} Vcc_1 = V\acute{c}c_2 \\ V\acute{c}c_1 = Vcc_2 \end{cases}$

$\begin{cases} O_2 : I'_1 \\ O_1 : I'_2 \end{cases}$

$\begin{cases} E_1 : I_1 \\ E_2 : I_2 \end{cases}$

EP 0 865 164 B1

FIG.3b.

FIG.4

EP 0 865 164 B1